# EUROPEAN PATENT SPECIFICATION

(11) **EP 2 935 884 B1**
(45) Date of publication and mention of the grant of the patent: **08.08.2018**
(21) Application number: 13810954.1
(22) Date of filing: 19.12.2013
(51) Int. Cl.: F04B 1/20, F04B 1/32, H01L 41/12

(54) **SWASHPLATE POSITION SENSOR ARRANGEMENT**
POSITIONSSENSORANORDNUNG FÜR TAUMELSCHEIBE
AGENCEMENT DE CAPTEUR DE POSITION DE PLATEAU EN BIAIS

(30) Priority: 20.12.2012 GB 201223048
(43) Date of publication of application: 28.10.2015
(73) Proprietor: Eaton Intelligent Power Limited, Dublin 4 (IE)
(72) Inventor: LINDNER, Henrik, 61169 Friedberg (DE); MEITINGER, Markus, 65817 Eppstein (DE)
(74) Representative: Eaton IP Group EMEA
(86) International application number: PCT/EP2013/077286
(87) International publication number: WO 2014/096129

(56) References cited:
- EP-A2- 0 419 984
- WO-A1-2012/014128
- JP-A- 2009 197 709
- US-A1- 2005 084 387
- US-B2- 6 623 247

## Description

The invention is related to a variable displacement hydraulic pump comprising a sensor arrangement for determining an actual swashplate angle of a swashplate, and to a measurement method for determining an actual swashplate angle of a swashplate pivotally attached to a variable displacement hydraulic pump.

Variable displacement hydraulic pumps, such as axial piston variable displacement pumps, are widely used in hydraulic systems to provide pressurized hydraulic fluid for various applications. For example, hydraulic earthworking and construction machines, e.g., excavators, bulldozers, loaders, and the like, rely heavily on hydraulic systems to operate, and hence often use variable displacement hydraulic pumps to provide the needed pressurized fluid. These pumps are driven by a mechanical shaft, for example by an engine, and the discharge flow rate, and hence the pressure, is regulated by controlling the angle of a swashplate pivotally mounted to the pump. Operation of the pump, however, is subject to variations in pressure and flow output caused by variations in load requirements. It is desirable to maintain the discharge flow rate of the pumps in a consistent manner so that operation of the hydraulic systems is well behaved and predictable. Therefore, attempts have been made to set up a control process including a step of sensing the swash plate position by a rotative sensor sensing the swivelling angle of the swash plate that is related to the pump stroke and hence the discharge flow rate.

In US Patent No. 6,623,247 B2, a method and apparatus for controlling a variable displacement hydraulic pump having a swashplate pivotally attached to the pump is disclosed. The method and apparatus includes determining a desired swashplate angle as a function of a power limit of the pump, determining an actual swashplate angle, determining a value of discharge pressure of the pump, moving a servo valve spool to a desired position as a function of the desired swash-plate angle, the actual swashplate angle and the discharge pressure, and responsively moving the swashplate to the desired swashplate angle position. A means for determining the actual swashplate angle is adapted to determine the angle of the swashplate using a swashplate angle sensor, for example, a resolver or a strain gauge.

In WO 2012/014128 a variable displacement hydraulic pump is disclosed.

EP 0 419 984 A2 discloses a variable displacement in-line or axial piston pump. Sensors responsive to pump operating conditions are connected to the pump control electronics, and include a first sensor responsive to yoke position, a pressure sensor responsive to pump output pressure and a speed sensor responsive to angular velocity of shaft rotation.

JP 2009-197709 A discloses a compact swash plate type variable displacement hydraulic pump with reduced wear, according to the preamble of claim 1. The swash plate type variable displacement hydraulic pump comprises a cylinder barrel rotated around the axis of rotation, a plurality of axial cylinders, a piston which is inserted in each axial cylinder so as to be reciprocated, a swash plate, and a controller for controlling the angle of the inclination of the swash plate. The controller includes a control cylinder having a control piston connected to the swash plate, and a non-contact linear displacement sensor for directly detecting the displacement of the control piston, using a magnetostrictive linear displacement sensor as a non-contact linear displacement sensor.

A problem is incurred by the control loop including a proportional valve being actuated by a controller, the proportional valve moving a control piston, the control piston swivelling the swashplate via a position member and, finally, sensing the swivelling angle of the swash plate as a feedback signal to the controller, because the number of clearances in the control loop may cause instable operation of the control process. A drawback of the magnetostrictive sensor is a possible interference of signals.

The present invention is directed to providing a more stable control of a variable displacement hydraulic pump.

The objective is accomplished by the variable displacement hydraulic pump and measurement method according to the independent claims. Preferred and advantageous embodiments are subject to the dependent claims.

The variable displacement hydraulics pump comprises a sensor arrangement for determining an actual swashplate angle of a swashplate pivotally attached to the variable displacement hydraulic pump as set out in claim 1. By using such a sensor arrangement, all clearances in the control loop are advantageously eliminated. This allows for a more stable pump control compared to the existing design.

According to a preferred embodiment, the sensor is adapted to detect the movement of the position marker in a contactless manner. The contactless sensor arrangement advantageously provides a completely wear-free design.

Furthermore preferred, the sensor is arranged generally parallel or coaxially to a direction of movement of the control piston. In particular, the sensor is a linear magnetostrictive position sensor and the position marker is a magnet.

The invention also provides for a measurement method for determining an actual swashplate angle of a swashplate pivotally attached to a variable displacement hydraulic pump, wherein a control piston is operable to control an angle of the swashplate relative to the pump, wherein the method comprises the steps of detecting a position of a position marker arranged on the control piston by a sensor arranged along the control piston and determining a linear translation of the control piston from a shift of the position marker relative to the sensor. In particular, the actual swashplate angle of the swashplate is determined from the linear translation of the control piston.

More advantages and details will become apparent from an embodiment according to the invention which will be described with respect to the attached drawings.

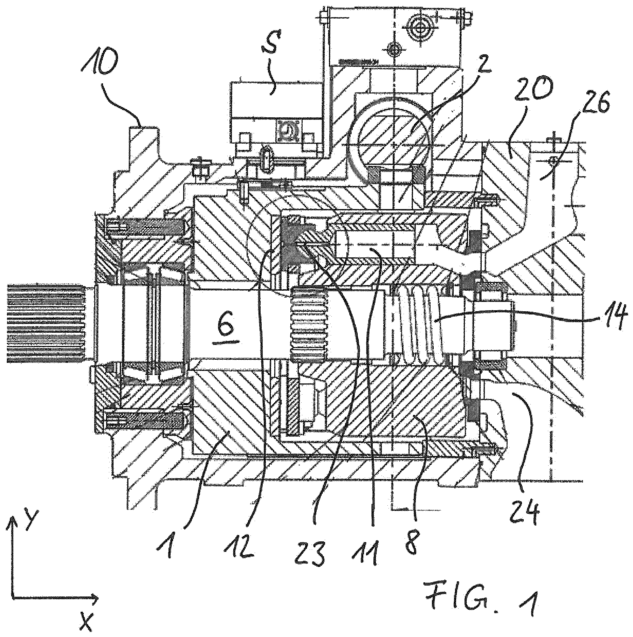

In the drawings:Figure 1 shows a sectional view of a variable displacement hydraulic pump with a rotative sensor according to the state of the art;
Figure 2 shows a sectional view of a variable displacement hydraulic pump with an embodiment of the sensor arrangement according to the invention;
Figure 3 shows a schematic illustration of the sensor arrangement in detail.

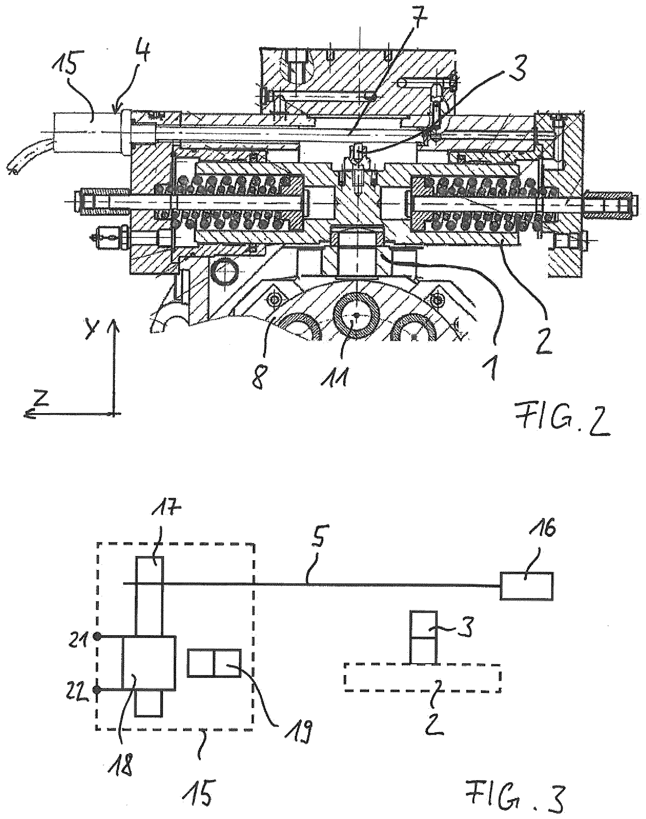

Referring to the drawings, in Figure 1, a sectional view in a X-Y plane of a variable displacement hydraulic pump 10 with a rotative sensor S according to the state of the art is depicted. The sensor arrangement according to the invention will be described with respect to Figure 2, wherein an identical variable displacement hydraulic pump 10 is depicted in a sectional view in a Y-Z plane. The following description refers to both the method and apparatus according to the invention.

With particular reference to Figures 1 and 2, the variable displacement hydraulic pump 10, hereinafter also referred to as pump 10, is preferably an axial piston swashplate hydraulic pump 10 having a plurality of pistons 11, e.g., seven or nine, located in a circular array within a cylinder block 8. Preferably, the pistons 11 are spaced at equal intervals about a shaft 6, located at a longitudinal center axis of the block 8. The cylinder block 8 is compressed tightly against a valve plate 20 by means of a cylinder block spring 14. The valve plate includes an intake port 24 and a discharge port 26. Each piston 11 is connected to a slipper 12, preferably by means of a ball and socket joint 23. Each slipper 12 is maintained in contact with a swash-plate 1. The swashplate 1 is inclinably mounted to the pump 10, the angle of inclination being controllably adjustable. With continued reference to Figures 1 and 2, operation of the pump 10 is illustrated. The cylinder block 8 rotates at a constant angular velocity. As a result, each piston 11 periodically passes over each of the intake and discharge ports 24, 26 of the valve plate 20. The angle of inclination of the swashplate 1 causes the pistons 11 to undergo an oscillatory displacement in and out of the cylinder block 8, thus drawing hydraulic fluid into the intake port 24, which is a low pressure port, and out of the discharge port 26, which is a high pressure port. In the preferred embodiment, the angle of inclination a of the swashplate 1 inclines about a swashplate pivot axis in X-direction and is controlled by a control piston 2. The control piston 2 operates to increase the angle of inclination of the swashplate 1, thus increasing the stroke of the pump 10. The pump 10 provides pressurized hydraulic fluid to the discharge port 26 of the valve plate 20.

Referring now to Figure 1, according to the state of the art, means for determining an actual swashplate angle is adapted to determine the angle of the swashplate 1. In Figure 1, the means for determining an actual swashplate angle includes a swashplate angle sensor S, which in the shown example is a resolver connected to the swashplate 1.

A sensor arrangement according to the invention is now described with respect to Figure 2. The sensor arrangement comprises the control piston 2 operable to control the angle of the swashplate 1 relative to the pump 10, a position marker 3 arranged on the control piston 2 and a sensor 4 arranged along the control piston 2 to detect a movement of the position marker 3. In the depicted embodiment, the sensor 4 is aligned in parallel to the centre axis of the control piston 2. Alternatively, the sensor 4 could be arranged coaxially, inside the control piston 2. By using such a sensor arrangement, all clearances in the control loop are advantageously eliminated. This allows for a much more stable pump control compared to the existing design. Further, a contactless sensor arrangement may advantageously be applied, thus providing a completely wear-free design.

The preferred embodiment of the sensor arrangement of Figure 2 comprises a linear magnetostrictive position sensor 4 arranged generally parallel to a direction of movement of the control piston 2, wherein the position marker 3 is a magnet 3. Magnetostriction is a property of ferromagnetic materials such as iron, nickel, and cobalt. When placed in a magnetic field, these materials change size and/or shape. Interaction of an external magnetic field with the magnetic domains causes the magnetostrictive effect. The ferromagnetic materials used in magnetostrictive position sensors 4 are transition metals such as iron, nickel, and cobalt. Vice versa, applying stress to a magnetostrictive material changes its magnetic properties, e.g., magnetic permeability. This is called the Villari effect. Magnetostriction and the Villari effect are preferably both used in producing the magnetostrictive position sensor 4, comprising a wire 5 (cf. Figure 3) made of a magnetostrictive material. The wire 5 is enclosed within a protective cover 7 and is attached to the stationary part of the pump 10.

Details of the sensor arrangement are now described with reference to the schematic illustration of Figure 3. An important characteristic of the wire 5 made of a magnetostrictive material is the Wiedemann effect. When an axial magnetic field is applied by the position marker magnet 3 to the magnetostrictive wire 5, and a current is passed through the wire 5, a twisting occurs at the location of the axial magnetic field. The twisting is caused by interaction of the axial magnetic field of magnet 3, usually a permanent magnet, with the magnetic field along the magnetostrictive wire 5, which is present due to the current in the wire 5. The current is applied, e.g., as a short-duration pulse of one or two µs, and the resulting mechanical twisting travels along the wire 5 as an ultrasonic wave. The magnetostrictive wire 5 is therefore also called waveguide 5. The wave travels at the speed of sound in the waveguide material, about 3000 m/s. In operation of a magnetostrictive position sensor 4, the interaction of the current pulse with the position magnet 3 generates a strain pulse that travels down the waveguide 5 and is detected by a pickup element 15. The axial magnetic field is provided by the position magnet 3. The position magnet 3 is attached to the control piston 2. The protective cover 7 enclosing the waveguide wire 5 is not illustrated. The location of the position magnet 3 is determined by first applying a current pulse to the waveguide 5. The current pulse causes a sonic wave to be generated at the location of the position magnet 3. The sonic wave travels along the waveguide 5 until it is detected by the pickup 15. The elapsed time then represents the distance between the position magnet 3 and the pickup 15. In order to avoid an interfering signal from waves travelling in a direction away from the pickup 15, their energy is absorbed by a damping device 16. The pickup 15 makes use of the Villari effect. A small piece of magnetostrictive material tape 17 is welded to the waveguide 5 near one end of the waveguide 5. This tape 17 passes through a coil 18 and is magnetized by a small permanent bias magnet 19. When a sonic wave propagates down the waveguide 5 and then down the tape 17, the stress induced by the wave causes a wave of changed permeability in the tape 17. This in turn causes a change in the tape magnetic flux density, and thus a voltage output pulse is produced from the coil 18, due to the Faraday effect. The voltage pulse is detected at the coil contacts 21, 22 by an electronic circuitry (not depicted) and conditioned into a desired output.

### Reference Numerals

- 1: swashplate
- 2: control piston
- 3: position marker, position magnet
- 4: sensor
- 5: wire, waveguide
- 6: shaft
- 7: protective cover
- 8: cylinder block
- 10: variable displacement hydraulic pump
- 11: piston
- 12: slipper
- 14: cylinder block spring
- 15: pickup
- 16: damping element
- 17: tape
- 18: coil
- 19: permanent bias magnet
- 20: valve plate
- 21, 22: coil contacts
- 23: ball and socket joint
- 24: intake port
- 26: discharge port
- S: resolver

## Claims

1. Variable displacement hydraulic pump (10) comprising a swashplate (1) pivotally attached to the pump (10) and a control piston (2) operable to control an angle of the swashplate (1) relative to the pump, further comprising a sensor arrangement for determining the actual swashplate angle of the swash-plate (1), wherein the sensor arrangement comprises a position marker (3) arranged on the control piston (2); and a sensor (4) arranged along the control piston to detect a linear movement of the control piston from a shift of the position marker (3) relative to the sensor (4), wherein the sensor (4) is a linear magnetostrictive position sensor comprising a wire (5) made of a magnetostrictive material, the position marker (3) being a magnet, wherein in operation of the position sensor (4), a current pulse through the wire (5) interacts with an axial magnetic field of the position marker (3), generating a strain pulse traveling down the wire to a pickup element (15) for detecting the strain pulse,
**characterized in that** a damping device (16) is provided to absorb energy of strain pulses travelling in a direction away from the pickup element (15).

2. Variable displacement hydraulic pump (10) according to claim 1, wherein the sensor (4) is adapted to detect the movement of the position marker (3) in a contactless manner.

3. Variable displacement hydraulic pump (10) according to any one of the preceding claims, wherein the sensor (4) is arranged generally parallel or coaxially to a direction of movement of the control piston (2).

4. Variable displacement hydraulic pump (10) according to any one of the preceding claims, wherein the control piston (2) is actuated by a proportional valve.

5. Measurement method for determining an actual swashplate angle of a swash-plate pivotally attached to a variable displacement hydraulic pump according to any one of the preceding claims, wherein the control piston (2) is operable to control an angle of the swashplate (1) relative to the pump; comprising the steps of:
detecting the position of the position marker (3) arranged on the control piston (2) by the sensor (4) arranged along the control piston, and
determining a linear translation of the control piston from a shift of the position marker relative to the sensor.

6. Method according to claim 5, wherein the actual swashplate angle of the swashplate (1) is determined from the linear translation of the control piston (2).

## Patentansprüche

1. Verstellbare hydraulische Verdrängungspumpe (10) umfassend eine Taumelscheibe (1), die an der Pumpe (10) schwenkbar befestigt ist, und einen Steuerkolben (2), der betriebsbereit ist, um einen Winkel der Taumelscheibe (1) bezogen auf die Pumpe zu steuern, weiter umfassend eine Sensoranordnung zum Bestimmen des aktuellen Taumelscheibenwinkels der Taumelscheibe (1), wobei die Sensoranordnung eine Positionsmarkierung (3), die auf dem Steuerkolben (2) angeordnet ist, und einen Sensor (4) umfasst, der entlang des Steuerkolbens angeordnet ist, um eine lineare Bewegung des Steuerkolbens durch eine Verschiebung der Positionsmarkierung (3) bezogen auf den Sensor (4) zu detektieren, wobei der Sensor (4) ein linearer magnetostriktiver Positionssensor ist, der einen Draht (5) aus einem magnetostriktiven Material umfasst, wobei die Positionsmarkierung (3) ein Magnet ist, wobei während einem Betrieb des Positionssensors (4) ein Stromimpuls durch den Draht (5) mit einem axialen Magnetfeld der Positionsmarkierung (3) interagiert, wodurch ein Spannungsimpuls erzeugt wird, der sich den Draht hinunter zu einem Aufnahmeelement (15) zum Detektieren des Spannungsimpulses bewegt, **dadurch gekennzeichnet, dass** eine Dämpfungsvorrichtung (16) vorgesehen ist, um Energie von Spannungsimpulsen zu absorbieren, die sich in einer Richtung weg von dem Aufnahmeelement (15) bewegen.

2. Verstellbare hydraulische Verdrängungspumpe (10) nach Anspruch 1, wobei der Sensor (4) angepasst ist, um die Bewegung der Positionsmarkierung (3) auf eine berührungslose Art und Weise zu detektieren.

3. Verstellbare hydraulische Verdrängungspumpe (10) nach einem der vorstehenden Ansprüche, wobei der Sensor (4) im Allgemeinen parallel oder koaxial zu einer Bewegungsrichtung des Steuerkolbens (2) angeordnet ist.

4. Verstellbare hydraulische Verdrängungspumpe (10) nach einem der vorstehenden Ansprüche, wobei der Steuerkolben (2) durch ein Proportionalventil betätigt wird.

5. Messverfahren zum Bestimmen eines aktuellen Taumelscheibenwinkels von einer Taumelscheibe, die an einer verstellbaren hydraulischen Verdrängungspumpe nach einem der vorstehenden Ansprüche schwenkbar befestigt ist, wobei der Steuerkolben (2) betriebsbereit ist, um einen Winkel der Taumelscheibe (1) bezogen auf die Pumpe zu steuern, umfassend die Schritte von:
Detektieren der Position der Positionsmarkierung (3), die an dem Steuerkolben (2) angeordnet ist, durch einen Sensor (4), der entlang des Steuerkolbens angeordnet ist, und
Bestimmen einer linearen Translation des Steuerkolbens durch eine Verschiebung der Positionsmarkierung bezogen auf den Sensor.

6. Verfahren nach Anspruch 5, wobei der aktuelle Taumelscheibenwinkel der Taumelscheibe (1) aus der linearen Translation des Steuerkolbens (2) bestimmt wird.

## Revendications

1. Pompe hydraulique à cylindrée variable (10) comprenant un plateau en biais (1) fixé de manière pivotante à la pompe (10) et un piston de commande (2) actionnable pour commander un angle du plateau en biais (1) par rapport à la pompe, comprenant en outre un agencement de capteur pour déterminer l'angle réel de plateau en biais du plateau en biais (1), dans laquelle l'agencement de capteur comprend un marqueur de position (3) agencé sur le piston de commande (2) ; et un capteur (4) agencé le long du piston de commande pour détecter un mouvement linéaire du piston de commande à partir d'un décalage du marqueur de position (3) par rapport au capteur (4), dans laquelle le capteur (4) est un capteur de position linéaire magnétostrictif comprenant un fil métallique (5) fait d'un matériau magnétostrictif, le marqueur de position (3) étant un aimant, dans laquelle, lors de l'actionnement du capteur de position (4), une impulsion de courant à travers le fil métallique (5) interagit avec un champ magnétique axial du marqueur de position (3), générant une impulsion de déformation circulant le long du fil métallique jusqu'à un élément de captage (15) pour détecter l'impulsion de déformation, **caractérisée en ce qu'**un dispositif d'amortissement (16) est fourni pour absorber l'énergie d'impulsions de déformation circulant dans une direction à l'opposé de l'élément de captage (15).

2. Pompe hydraulique à cylindrée variable (10) selon la revendication 1, dans laquelle le capteur (4) est adapté pour détecter le déplacement du marqueur de position (3) d'une manière sans contact.

3. Pompe hydraulique à cylindrée variable (10) selon l'une quelconque des revendications précédentes, dans laquelle le capteur (4) est agencé généralement parallèlement ou de manière coaxiale avec une direction de déplacement du piston de commande (2).

4. Pompe hydraulique à cylindrée variable (10) selon l'une quelconque des revendications précédentes, dans laquelle le piston de commande (2) est actionné par une vanne proportionnelle.

5. Procédé de mesure pour la détermination d'un angle réel de plateau en biais d'un plateau en biais fixé de manière pivotante à une pompe hydraulique à cylindrée variable selon l'une quelconque des revendications précédentes, dans lequel le piston de commande (2) est actionnable pour commander un angle du plateau en biais (1) par rapport à la pompe ; comprenant les étapes de :
détection de la position du marqueur de position (3) agencé sur le piston de commande (2) par le capteur (4) agencé le long du piston de commande, et
détermination d'une translation linéaire du piston de commande à partir d'un décalage du marqueur de position par rapport au capteur.

6. Procédé selon la revendication 5, dans lequel l'angle réel de plateau en biais du plateau en biais (1) est déterminé à partir de la translation linéaire du piston de commande (2).
